(19) Europäisches Patentamt
European Patent Office
Office européen des brevets

(11) EP 0 745 902 B1

(12) EUROPEAN PATENT SPECIFICATION

(45) Date of publication and mention of the grant of the patent:
**28.04.1999 Bulletin 1999/17**

(51) Int Cl.[6]: **G03F 7/07**, G03C 8/06

(21) Application number: **96201419.7**

(22) Date of filing: **20.05.1996**

(54) **Improvement of the storage stability of an imaging element for making a printing plate according to the silver salt diffusion transfer process**

Verbesserung der Lagerfähigkeit von einem Bildelement zur Herstellung einer Druckplatte nach dem Silbersalz-Diffusionsübertragungsverfahren

Amélioration de la stabilité au stockage d'un élément formateur d'image pour la fabrication d'une plaque d'impression au moyen du procédé de diffusion-transfert de sel d'argent

(84) Designated Contracting States:
**BE DE FR GB**

(30) Priority: **01.06.1995 EP 95201435**

(43) Date of publication of application:
**04.12.1996 Bulletin 1996/49**

(73) Proprietor: **AGFA-GEVAERT N.V.**
**2640 Mortsel (BE)**

(72) Inventors:
- **Coppens, Paul, c/o Agfa-Gevaert N.V., IIE 3811 2640 Mortsel (BE)**
- **Hoes, Eric, c/o Agfa-Gevaert N.V., IIE 3811 2640 Mortsel (BE)**
- **Berendsen, Jules, c/o Agfa-Gevaert N.V., IIE 3811 2640 Mortsel (BE)**
- **Vandenbruwaene, Rik, c/o Agfa-Gevaert NV, IIE 3811 2640 Mortsel (BE)**

(56) References cited:
**EP-A- 0 449 340**
**EP-A- 0 637 778**
**DE-A- 1 964 002**

- **PATENT ABSTRACTS OF JAPAN vol. 6, no. 30 (P-103) [908] , 23 February 1982 & JP-A-56 150742 (MITSUBISHI SEISHI), 21 November 1981,**
- **PATENT ABSTRACTS OF JAPAN vol. 9, no. 329 (P-416) [2052] , 24 December 1985 & JP-A-60 154247 (FUJI SHASHIN FILM), 13 August 1985,**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 745 902 B1

## Description

1. Field of the invention.

The present invention relates to an imaging element for an improved making of lithographic printing plates according to the silver salt diffusion transfer process.

The present invention further relates to a method for an improved making of lithographic printing plates according to the silver salt diffusion transfer process.

2. Background of the invention.

The principles of the silver complex diffusion transfer reversal process, hereinafter called DTR-process, have been described e.g. in US-P-2,352,014 and in the book "Photographic Silver Halide Diffusion Processes" by André Rott and Edith Weyde - The Focal Press - London and New York, (1972).

In the DTR-process non-developed silver halide of an information-wise exposed photographic silver halide emulsion layer material is transformed with a so-called silver halide solvent into soluble silver complex compounds which are allowed to diffuse into an image receiving element and are reduced therein with a developing agent, generally in the presence of physical development nuclei, to form a silver image having reversed image density values ("DTR-image") with respect to the black silver image obtained in the exposed areas of the photographic material.

A DTR-image bearing material can be used as a planographic printing plate wherein the DTR-silver image areas form the water-repellent ink-receptive areas on a water-receptive ink-repellent background.

The DTR-image can be formed in the image receiving layer of a sheet or web material which is a separate element with respect to the photographic silver halide emulsion material (a so-called two-sheet DTR element) or in the image receiving layer of a so-called single-support-element, also called mono-sheet element, which contains at least one photographic silver halide emulsion layer integral with an image receiving layer in waterpermeable relationship therewith. It is the latter mono-sheet version which is preferred for the preparation of offset printing plates by the DTR method.

Two types of the mono-sheet DTR imaging element exist. According to a first type disclosed in e.g. US-P-4,722,535 and GB-1,241,661 a support is provided in the order given with a silver halide emulsion layer and a layer containing physical development nuclei serving as the image-receiving layer. After information-wise exposure and development the imaged element is used as a printing plate without the removal of the emulsion layer.

According to a second type of mono-sheet DTR imaging element a hydrophilic support, mostly anodized aluminum, is provided in the order given with a layer of physical development nuclei and a silver halide emulsion layer. After information-wise exposure and development the imaged element is treated to remove the emulsion layer so that a support carrying a silver image is left wich is used as a printing plate. Such type of lithographic printing plate is disclosed e.g. in US-P-3,511,656.

As for other imaging elements it is required that the imaging elements belonging to the second type of mono-sheet DTR imaging elements have good sensitometric properties which remain stable upon storage of the imaging element. It has however been found that the sensitivity of an imaging element belonging to the second type of mono-sheet DTR imaging elements increase upon storage of the imaging element so that an appropriate exposure of such an imaging element as the first step in order to obtain a lithographic printing plate becomes practically impossible.

3. Summary of the invention.

It is an object of the present invention to provide an imaging element for making offset printing plates according to the silver salt diffusion transfer process having an improved storage stability.

It is another object of the present invention to provide a method for making offset printing plates with said imaging element .

Further objects of the present invention will become clear from the description hereinafter.

According to the present invention there is provided an imaging element comprising in the order given on a hydrophilic surface of a support (i) an image receiving layer containing physical development nuclei and (ii) a photosensitive layer containing a silver halide emulsion being in water permeable relationship with said image receiving layer, characterized in that said photosensitive layer comprises a substituted or unsubstituted 1-phenyl-3-pyrazolidone in an amount between 0.2 mg/g and 15 mg/g of silver halide expressed as an equivalent amount of silver nitrate.

According to the present invention there is also provided a method for making an offset printing plate according to the silver salt diffusion transfer process comprising the steps of:

(a) image-wise exposing an imaging element according to the present invention,

(b) applying an aqueous alkaline solution to the imaging element in the presence of (a) developing agent(s) and (a) silver halide solvent(s) ,

(c) treating the imaging element to remove the layer(s) on top of said image receiving layer, thereby uncovering said silver image formed in said image receiving layer.

4. Detailed description of the invention.

It has been found that the storage stability of the sensitivity of an imaging element belonging to the second type of mono-sheet DTR imaging elements can be improved by using an imaging element wherein the photosensitive layer comprises a substituted or unsubstituted 1-phenyl-3-pyrazolidone in an amount between 0.2 mg/g and 15 mg/g of silver halide expressed as an equivalent amount of silver nitrate.

EP-A-449340 discloses 1-phenyl-3-pyrazolidone derivatives with a group capable of adsorbing at the surface of silver halides as compounds which can inhibit fog on storage of a photographic material, especially a DTR-material without lowering the sensitivity of said material. EP-A-449340 however does not disclose the use of 1-phenyl-3-pyrazolidone derivatives as substances capable of avoiding a sensitivity increase when storing a DTR-material. Furtheron EP-A-449340 does not disclose imaging elements belonging to the second type of mono-sheet DTR imaging elements but is especially concerned with red-sensitized imaging elements belonging to the first type of mono-sheet DTR imaging elements.

Preferably a 1-phenyl-3-pyrazolidone substituted in the 4 position is used, more preferably 1-phenyl-4-hydroxymethyl-4-methyl-3-pyrazolidone, most preferably 1-phenyl-4-methyl-3-pyrazolidone.

The substituted or unsubstituted l-phenyl-3-pyrazolidone is preferably used in an amount between 0.4 mg/g and 12 mg/g, more preferably in an amount between 1 and 10 mg/g of silver halide expressed as an equivalent amount of silver nitrate.

The imaging element is preferably prepared by coating the different layers on a hydrophilic surface of a support. Alternatively the different layers may be laminated to said image receiving layer from a temporary base holding the layers in reverse order as disclosed in US-P 5,068,165.

Said hydrophilic surface of a support can be a hardened hydrophilic layer, containing a hydrophilic binder and a hardening agent coated on a flexible support.

Such hydrophilic binders are disclosed in e.g. EP-A 450,199, which therefor is incorporated herein by reference. Preferred hardened hydrophilic layers comprise partially modified dextrans or pullulan hardened with an aldehyde as disclosed in e.g. EP-A 514,990 which therefor is incorporated herein by reference. More preferred hydrophilic layers are layers of polyvinyl alcohol hardened with a tetraalkyl orthosilicate and preferably containing $SiO_2$ and/or $TiO_2$ wherein the weight ratio between said polyvinylalcohol and said tetraalkyl orthosilicate is between 0.5 and 5 as disclosed in e.g. GB-P 1,419,512, FR-P 2,300,354, US-P-3,971,660, US-P 4,284,705, EP-A 405,016 and EP-A 450,199.

Flexible supports may be opaque or transparent, e.g. a paper support or resin support. When a paper support is used preference is given to one coated at one or both sides with an Alpha-olefin polymer. It is also possible to use an organic resin support e.g. poly(ethylene terephthalate) film or poly-Alpha-olefin films. The thickness of such organic resin film is preferably comprised between 0.07 and 0.35 mm. These organic resin supports are preferably coated with a hydrophilic adhesion layer which can contain water insoluble particles such as silica or titanium dioxide.

Said hydrophilic surface of a support is preferably a hydrophilic metallic support e.g. an aluminium foil.

The aluminum support of the imaging element for use in accordance with the present invention can be made of pure aluminum or of an aluminum alloy, the aluminum content of which is at least 95%. The thickness of the support usually ranges from about 0.13 to about 0.50 mm.

The preparation of aluminum or aluminum alloy foils for lithographic offset printing comprises the following steps : graining, anodizing, and optionally sealing of the foil.

Graining and anodization of the foil are necessary to obtain a lithographic printing plate that allows to produce high-quality prints in accordance with the present invention. Sealing is not necessary but may still improve the printing results. Preferably the aluminum foil has a roughness with a CLA value between 0.2 and 1.5 μm, an anodization layer with a thickness between 0.4 and 2.0 μm and is posttreated with an aqueous bicarbonate solution.

According to the present invention the roughening of the aluminum foil can be performed according to the methods well known in the prior art. The surface of the aluminum substrate can be roughened either by mechanical, chemical or electrochemical graining or by a combination of these to obtain a satisfactory adhesiveness of a silver halide emulsion layer to the aluminum support and to provide a good water retention property to the areas that will form the non-printing areas on the plate surface.

The electrochemical graining process is preferred because it can form a uniform surface roughness having a large average surface area with a very fine and even grain which is commonly desired when used for lithographic printing plates.

The roughening is preferably preceded by a degreasing treatment mainly for removing greasy substances

from the surface of the aluminum foil.

Therefore the aluminum foil may be subjected to a degreasing treatment with a surfactant and/or an aqueous alkaline solution.

Preferably roughening is followed by a chemical etching step using an aqueous solution containing an acid. The chemical etching is preferably carried out at a temperature of at least 30°C more preferably at least 40°C and most preferably at least 50°C.

After roughening and optional chemical etching the aluminum foil is anodized which may be carried out as follows.

An electric current is passed through the grained aluminum foil immersed as an anode in a solution containing an acid. An electrolyte concentration from 1 to 70 % by weight can be used within a temperature range from 0-70°C. The anodic current density may vary from 1-50 A/$dm^2$ and a voltage within the range 1-100 V to obtain an anodized film weight of 1-8 g/$m^2$ $Al_2O_3.H_2O$. The anodized aluminum foil may subsequently be rinsed with demineralised water within a temperature range of 10-80°C.

After the anodizing step sealing may be applied to the anodic surface. Sealing of the pores of the aluminum oxide layer formed by anodization is a technique known to those skilled in the art of aluminum anodization. This technique has been described in e.g. the "Belgisch-Nederlands tijdschrift voor Oppervlaktetechnieken van materialen", 24ste jaargang/januari 1980, under the title "Sealing-kwaliteit en sealing-controle van geanodiseerd Aluminium". Different types of sealing of the porous anodized aluminum surface exist.

Preferably, said sealing is performed by treating a grained and anodized aluminum support with an aqueous solution containing a bicarbonate as disclosed in EP-A 567178.

Preferably each of the above described steps is separated by a rinsing step to avoid contamination of the liquid used in a particular step with that of the preceding step.

To promote the image sharpness and, as a consequence thereof, the sharpness of the final printed copy, the anodization layer may be coloured in the mass with an antihalation dye or pigment e.g. as described in JA-Pu-58-14,797.

Subsequent to the preparation of the hydrophilic layer of a support as described above, said hydrophilic layer may be immediately coated with a solution containing the physical development nuclei or may be coated with said solution at a later stage.

The image receiving layer preferably comprises physical development nuclei in an amount ranging from 0.1 mg to 20 mg/$m^2$. The image receiving layer containing physical development nuclei may be free of hydrophilic binder but preferably comprises small amounts upto 80% by weight of the total weight of said layer of a hydrophilic colloid e. g. polyvinyl alcohol to improve the hydrophilicity of the surface.

Preferred development nuclei for use in accordance with the present invention are sulphides of heavy metals e.g. sulphides of antimony, bismuth, cadmium, cobalt, lead, nickel, palladium, platinum, silver, and zinc. Especially suitable development nuclei in connection with the present invention are palladium sulphide nuclei. Other suitable development nuclei are salts such as e.g. selenides, polyselenides, polysulphides, mercaptans, and tin (II) halides. Heavy metals, preferably silver, gold, platinum, palladium, and mercury can be used in colloidal form.

To promote the image sharpness and, as a consequence thereof, the sharpness of the final printed copy, the hydrophilic base can be provided with a very thin antihalation coating of a dye or pigment, which may be applied before or after said image receiving layer is applied. Also to promote the image sharpness the image receiving layer may incorporate at least one antihalation dye or pigment. The usual dyes and pigments can be chosen such that they prevent or reduce halation in the silver halide emulsions having any desired photosensitivity range comprised between 300 and 900 nm.

According to the method of the present invention for obtaining a mono-sheet DTR material an aluminum foil prepared as described above and provided with an image receiving layer is provided with a photosensitive layer in water permeable contact with said image receiving layer.

Layers being in waterpermeable contact with each other are layers that are contiguous to each other or only separated from each other by (a) waterpermeable layer(s). The nature of a waterpermeable layer is such that it does not substantially inhibit or restrain the diffusion of water or of compounds contained in an aqueous solution e.g. developing agents or the complexed silver.

The photosensitive layer used according to the present invention may be any layer comprising a hydrophilic colloid binder and at least one silver halide emulsion, at least one of the silver halide emulsions being photosensitive.

The photographic silver halide emulsion(s) used in accordance with the present invention can be prepared from soluble silver salts and soluble halides according to different methods as described e.g. by P. Glafkides in "Chimie et Physique Photographique", Paul Montel, Paris (1967), by G.F. Duffin in "Photographic Emulsion Chemistry", The Focal Press, London (1966), and by V.L. Zelikman et al in "Making and Coating Photographic Emulsion", The Focal Press, London (1966).

The silver halide emulsion for use in connection with the present invention is a silver chlorobromide emulsions

that contain silver bromide in the range from 0.1 mole % to 40 mole % and that may contain upto 2 mole % of silver iodide. Preferably, the amount of silver bromide is between 1 mole % and 30 mole %. An emulsion comprising more than 5 mole % of silver bromide preferably belongs to the core/shell type well known to those skilled in the art in the sense that substantially all the bromide is concentrated in the core. This core contains preferably 10 to 40 % of the total silver halide precipitated, while the shell consist preferably of 60 to 90 % of the total silver precipitated. A particularly preferred silver halide emulsion of this type is described in US 5,059,508.

The average size of the silver halide grains may range from 0.10 to 0.70 µm , preferably from 0.25 to 0.45 µm.

Preferably during the precipitation stage iridium and/or rhodium containing compounds or a mixture of both are added. The concentration of these added compounds ranges from $10^{-8}$ to $10^{-3}$ mole per mole of $AgNO_3$, preferably between $10^{-7}$ and $10^{-5}$ mole per mole of $AgNO_3$.

The emulsions can be chemically sensitized e.g. by adding sulphur-containing compounds during the chemical ripening stage e.g. allyl isothiocyanate, allyl thiourea, and sodium thiosulphate. Also reducing agents e.g. the tin compounds described in BE-P 493,464 and 568,687, and polyamines such as diethylene triamine or derivatives of aminomethane-sulphonic acid can be used as chemical sensitizers. Other suitable chemical sensitizers are noble metals and noble metal compounds such as gold, platinum, palladium, iridium, ruthenium and rhodium. This method of chemical sensitization has been described in the article of R.KOSLOWSKY, Z. Wiss. Photogr. Photophys. Photochem. 46, 65-72 (1951).

Apart from negative-working silver halide emulsions that are preferred for their high photosensitivity, use can be made also of direct-positive silver halide emulsions that produce a positive silver image in the emulsion layer(s) and a negative image on the image-receiving layer.

Suitable direct positive silver halide emulsions for use in accordance with the present invention are silver halide emulsions that have been previously fogged or that mainly form an internal latent image.

The silver halide emulsions of the DTR-element can be spectrally sensitized according to the spectral emission of the exposure source for which the DTR element is designed.

Suitable sensitizing dyes for the visible spectral region include methine dyes such as those described by F. M. Hamer in "The Cyanine Dyes and Related Compounds", 1964, John Wiley & Sons. Dyes that can be used for this purpose include cyanine dyes, merocyanine dyes, complex cyanine dyes, complex merocyanine dyes, homopolar cyanine dyes, hemicyanine dyes, styryl dyes and hemioxonol dyes. Particularly valuable dyes are those belonging to the cyanine dyes, merocyanine dyes, complex merocyanine dyes.

In the case of a conventional light source, e.g. tungsten light, a green sensitizing dye is needed. In case of exposure by an argon ion laser a blue sensizing dye is incorporated. In case of exposure by a red light emitting source, e.g. a LED or a HeNe laser a red sensitizing dye is used. In case of exposure by a semiconductor laser special spectral sensitizing dyes suited for the near infra-red are required. Suitable infra-red sensitizing dyes are disclosed in i.a. US-P 2,095,854, 2,095,856, 2,955,939, 3,482,978, 3,552,974, 3,573,921, 3,582,344, 3,623,881 and 3,695.888.

A preferred blue sensitizing dye, green sensitizing dye, red sensitizing dye and infra-red sensitizing dye in connection with the present invention are described in EP-A 554,585.

To enhance the sensitivity in the red or near infra-red region use can be made of so-called supersensitizers in combination with red or infra-red sensitizing dyes. Suitable supersensitizers are described in Research Disclosure Vol 289, May 1988, item 28952. The spectral sensitizers can be added to the photographic emulsions in the form of an aqueous solution, a solution in an organic solvent or in the form of a dispersion.

The silver halide emulsions may contain the usual emulsion stabilizers. Suitable emulsion stabilizers are azaindenes, preferably tetra- or penta-azaindenes, especially those substituted with hydroxy or amino groups. Compounds of this kind have been described by BIRR in Z. Wiss. Photogr. Photophys. Photochem. 47, 2-27 (1952). Other suitable emulsion stabilizers are i.a. heterocyclic mercapto compounds, especially substituted or unsubstituted 1-phenyl-5-mercapto-tetrazole, particularly 1-phenyl-5-mercapto-tetrazoles substituted by the amido group $-NR_1-CO-R_2$ or $-NR_1-SO_2-R_2$ wherein $R_1$ represents hydrogen or $C_1$-$C_4$ alkyl and $R_2$ represents a hydrocarbon group selected from the group consisting of $C_1$-$C_8$ alkyl, aryl, and alkenyl wherein said hydrocarbon group is substituted by a -COOM group or a $-SO_3M$ group with M representing hydrogen,a metal cation or an ammonium group.

As binder in the silver halide emulsion layer(s) in connection with the present invention a hydrophilic colloid may be used, usually a protein, preferably gelatin. Gelatin can, however, be replaced in part or integrally by synthetic, semi-synthetic, or natural polymers. Preferably the silver halide emulsion layer contains at least one gelatin species whereof a 10 % by weight aqueous solution at 36 °C and pH 6 has a viscosity lower than 20 mPa.s at a shearing rate of 1000 $s^{-1}$ combined with a gelatin of a higher viscosity. The weight ratio of said low viscosity gelatin versus the gelatin of a higher viscosity is preferably > 0.5.

Preferably the gelatin layer(s) is(are) substantially unhardened. Substantially unhardened means that when such gelatin layer is coated on a subbed polyethylene terephtalate film base at a dry thickness of 1.2 $g/m^2$, dried for 3 days at 57 C° and 35% R.H. and dipped in water of 30 C°, said gelatin layer is dissolved for more than 95 % by weight within 5 minutes.

The silver halide emulsions may contain pH controlling ingredients. Preferably at least one gelatin containing layer is coated at a pH value not below the iso-electric point of the gelatin to avoid interactions between said gelatin containing coated layer and the hereafter mentioned intermediate layer. More preferably the gelatin layer contiguous to said intermediate layer is coated at a pH value not below the iso-electric point of the gelatin. Most preferably all the gelatin containing layers are coated at a pH value not below the iso-electric point of their gelatin. Other ingredients such as antifogging agents, development accelerators, wetting agents, and hardening agents for gelatin may be present. The silver halide emulsion layer may comprise light-screening dyes that absorb scattering light and thus promote the image sharpness. Suitable light-absorbing dyes are described in i.a. US-P 4,092,168, US-P 4,311,787 and DE-P 2,453,217.

More details about the composition, preparation and coating of silver halide emulsions suitable for use in accordance with the present invention can be found in e.g. Product Licensing Index, Vol. 92, December 1971, publication 9232, p. 107-109.

Preferably, the imaging element also comprises an intermediate layer between the image receiving layer on the hydrophilic surface of a support and the photosensitive layer(packet) to facilate the removal of said layer(packet) thereby uncovering the silver image formed in the image receiving layer by processing the imaging element.

In one embodiment, the intermediate layer is a water-swellable intermediate layer coated at a ratio of 0.01 to 2.0 g/m2 and comprising at least one non-proteinic hydrophilic film-forming polymer e.g. polyvinyl alcohol and optionally comprising an antihalation dye or pigment as disclosed in EP-A-410500.

In another embodiment, the intermediate layer is a layer comprising hydrophobic polymer beads having an average diameter not lower than 0.2 µm and having been prepared by polymerization of at least one ethylenically unsaturated monomer. Preferably, said intermediate layer in dry condition comprises said hydrophobic polymer beads in an amount of up to 80% of its total weight. Further details are disclosed in EP-A-483415.

A supplemental intermediate layer, which may be present between said silver halide emulsion containing layer and said water-swellable intermediate layer or said intermediate layer comprising hydrophobic polymer beads may incorporate one or more ingredients such as i.a. antihalation dyes or pigment, developing agents, silver halide solvents, base precursors, and anticorrosion substances.

When the imaging element is prepared by laminating a layer packet comprising a photosensitive layer onto the image receiving layer the intermediate layer(s) are provided on the photosensitive layer(s), the water-swellable intermediate layer or the intermediate layer comprising hydrophobic polymer beads having an average diameter not lower than 0.2 µm and having been prepared by polymerization of at least one ethylenically unsaturated monomer being the upper layer.

According to the present invention the imaging element can be information-wise exposed in an apparatus according to its particular application. A wide choice of cameras for exposing the photosensitive silver halide emulsion exists on the market. Horizontal, vertical and darkroom type cameras and contact-exposure apparatus are available to suit any particular class of reprographic work. The imaging element in accordance with the present invention can also be exposed with the aid of i.a. laser recorders and cathode rays tubes.

According to the present invention the development and diffusion transfer of the information-wise exposed imaging element in order to form a silver image in said photosensitive layer and to allow unreduced silver halide or complexes formed thereof to diffuse image-wise from the photosensitive layer to said image receiving layer to produce therein a silver image, are effected with the aid of an aqueous alkaline solution in the presence of (a) developing agent (s), and (a) silver halide solvent(s). The developing agent(s) and/or the silver halide solvent(s) can be incorporated in the aqueous alkaline solution and/or in the imaging element.

Preferably a silver halide solvent in the aqueous alkaline solution is used in an amount between 0.05% by weight and 5% by weight and more preferably between 0.5% by weight and 2% by weight. The silver halide solvent, which acts as a complexing agent for silver halide, preferably is a water-soluble thiosulphate or thiocyanate e.g. sodium, potassium, or ammonium thiosulphate and sodium, potassium, or ammonium thiocyanate.

Further silver halide solvents that can be used in connection with the present invention are e.g. sulphite, amines, 2-mercaptobenzoic acid, cyclic imide compounds such as e.g. uracil, 5,5-dialkylhydantoins, alkyl sulfones and oxazolidones.

Further silver halide solvents for use in connection with the present invention are alkanolamines. Examples of alkanolamines that may be used in connection with the present invention correspond to the following formula:

$$\begin{array}{l} C_1H_{21}\text{-}X \\ | \\ N\text{-}C_mH_{2m}\text{-}X' \\ | \\ C_nH_{2n}\text{-}OH \end{array}$$

wherein X and X' independently represent hydrogen, a hydroxyl group or an amino group, 1 and m represent 0 or integers of 1 or more and n represents an integer of 1 or more. Said alkanolamines may be present in the alkaline processing liquid in a concentration preferably between 0.1% and 5% by weight. However part or all of the alkanolamine can be present in one or more layers of the imaging element.

Still other preferred further silver halide solvents for use in connection with the present invention are thioethers. Preferably used thioethers correspond to the following general formula:

$$Z\text{-}(R^1\text{-}S)_t\text{-}R^2\text{-}S\text{-}R^3\text{-}Y$$

wherein Z and Y each independently represents hydrogen, an alkyl group, an amino group, an ammonium group, a hydroxyl, a sulfo group, a carboxyl, an aminocarbonyl or an aminosulfonyl, $R^1$, $R^2$ and $R^3$ each independently represents an alkylene that may be substituted and optionally contain an oxygen bridge and t represents an integer from 0 to 10. Examples of thioether compounds corresponding to the above formula are disclosed in e.g. US-P-4.960.683 and EP-A 554,585.

Still further suitable silver halide solvents are 1,2,4-triazolium-3-thiolates, triazolium-3-thiolates, preferably substituted with at least one substituent selected from the group consisting of a $C_1$-$C_8$ alkyl group that contains at least 3 fluorine atoms, a $C_4$-$C_{10}$ hydrocarbon group and a 4-amino group substituted with a $C_1$-$C_8$ alkyl group that contains at least 3 fluorine atoms and/or a $C_4$-$C_{10}$ hydrocarbon group.

Combinations of different silver halide solvents can be used and it is also possible to incorporate at least one silver halide solvent into a suitable layer of the imaging element and to add at least one other silver halide solvent to the developing solution.

The alkaline processing liquid may also contain (a) developing agent(s). In this case the alkaline processing liquid is called a developer. On the other hand some or all of the developing agent(s) may be present in one or more layers of the photographic material or imaging element. When all of the developing agents are contained in the imaging element the alkaline processing liquid is called an activator or activating liquid.

Silver halide developing agents for use in accordance with the present invention are preferably of the p-dihydroxybenzene type. e.g. hydroquinone, methylhydroquinone or chlorohydroquinone, preferably in combination with an auxiliary developing agent being a 1-phenyl-3-pyrazolidinone-type developing agent and/or p-monomethylaminophenol. Particularly useful auxiliary developing agents are the 1-phenyl-3-pyrazolidinones. Preferably at least part of the 1-phenyl-3-pyrazolidinones is present in the aqueous alkaline solution. However other developing agents can be used.

Preferred amounts of the hydroquinone-type developing agents are in the range of 0.05 mole to 0.40 mole per litre and preferred amounts of secondary developing agent(s) in the range of $1.8 \times 10^{-3}$ to $2.0 \times 10^{-1}$ mole per litre.

The aqueous alkaline solution in accordance with the present invention may further comprise sulphite e.g. sodium sulphite in an amount ranging from 40 g to 180 g per liter, preferably from 60 to 160 g per liter in combination with another silver halide solvent.

The quantitative ranges given for the developing agents, silver halide solvents, and sulphite apply to the amount of these compounds present as solutes in the aqueous alkaline solution during the DTR-processing, whether these compounds make part of the aqueous alkaline solution or were dissolved from the layers containing them upon application thereto of the aqueous alkaline solution.

The aqueous alkaline solution suitable for use according to the present invention preferably comprises aluminum ions in an amount of at least 0.3 g/l, more preferably in an amount of at least 0.6 g/l in order to prevent sticking of the emulsion layer to the transporting rollers when the emulsion is swollen with the aqueous alkaline solution.

The alkaline processing liquid preferably has a pH between 9 and 14 and more preferably between 10 and 13, but depends on the type of silver halide emulsion material to be developed, intended development time, and processing temperature.

The processing conditions such as temperature and time may vary within broad ranges provided the mechanical strength of the materials to be processed is not adversely influenced and no decomposition takes place.

The pH of the alkaline processing liquid may be established by an organic or inorganic alkaline substance or a combination thereof. Suitable inorganic alkaline substances are e.g. hydroxides of sodium and potassium, alkali metal salts of phosphoric acid and/or silicic acid e.g. trisodium phosphate, orthosilicates, metasilicates, hydrodisilicates of sodium or potassium, and sodium carbonate etc.. Suitable organic alkaline substances are e.g. alkanolamines. In the latter case the alkanolamines will provide or help providing the pH and serve as a silver halide complexing agent.

The aqueous alkaline solution may further comprise hydrophobizing agents for improving the hydrophobicity of the silver image obtained in the image receiving layer. Generally these compounds contain a mercapto group or thiolate group and one or more hydrophobic substituents. Particularly preferred hydrophobizing agents are mercapto-1,3,4-thiadiazoles as described in DE-A 1,228,927 and in US-P 4,563,410, 2-mercapto-5-heptyloxa-3,4-diazole, 3-mercapto-5-alkyl-1,2,4-triazoles and long chain (at least 5 carbon atoms) alkyl substituted mercaptotetrazoles. The hydrophobizing agents can be used alone or in combination with each other.

These hydrophobizing compounds can be added to the aqueous alkaline solution in an amount of preferably 0.1 to 3 g per litre and preferably in admixture with 1-phenyl-5-mercaptotetrazole, the latter compound may be used in amounts of e.g. 50 mg to 1.2 g per litre of solution, which may contain a minor amount of ethanol to improve the dissolution of said compounds.

The aqueous alkaline solution may comprise other ingredients such as e.g. oxidation preservatives, calcium-sequestering compounds, anti-sludge agents, and hardeners including latent hardeners.

Regeneration of the aqueous alkaline solution according to known methods is, of course, possible, whether the solution incorporates developing agent(s) and/or silver halide solvent(s) or not.

The development may be stopped - though this is often not necessary - with a so-called stabilization liquid, which actually is an acidic stop-bath having a pH preferably in the range from 5 to 7.

Bufferred stop bath compositions comprising a mixture of sodium dihydrogen orthophosphate and disodium hydrogen orthophosphate and having a pH in said range are preferred.

The development and diffusion transfer can be initiated in different ways e.g. by rubbing with a roller, by wiping with an absorbent means e.g. with a plug of cotton or sponge, or by dipping the material to be treated in the liquid composition. Preferably, they proceed in an automatically operated apparatus. They are normally carried out at a temperature in the range of 18°C to 30°C and in a time from 5 s to 5 min.

After formation of the silver image on the hydrophilic surface of a support an excess of aqueous alkaline solution still present on the base may be eliminated, preferably by guiding the foil through a pair of squeezing rollers.

The silver image thus obtained in the layer of physical development nuclei is subsequently uncovered by treating the imaging element to remove all the layers above the layer containing physical development nuclei, thereby exposing the imaged surface of the hydrophilic support.

According to a particularly preferred embodiment of the present invention the silver image in the layer of physical development nuclei is uncovered by washing off all the layers above the layer containing physical development nuclei with rinsing water.

The temperature of the rinsing water may be varied widely but is preferably between 30 °C and 50 °C, more preferably between 35°C and 45°C.

The imaged surface of the hydrophilic surface of a support can be subjected to a chemical treatment that increases the hydrophilicity of the non-silver image parts and the oleophilicity of the silver image

This chemical after-treatment is preferably carried out with a lithographic composition often called finisher comprising at least one compound enhancing the ink-receptivity and/or lacquer-receptivity of the silver image and at least one compound that improves the ink-repelling characteristics of the hydrophilic surface.

Suitable ingredients for the finisher are e.g. organic compounds containing a mercapto group such as the hydrophobizing compounds referred to hereinbefore for the alkaline solution. Preferred compounds correspond to one of the following formulas:

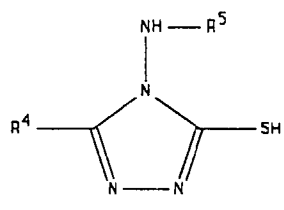

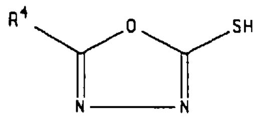

wherein $R^5$ represents hydrogen or an acyl group, $R^4$ represents alkyl, aryl or aralkyl. Most preferably used compounds are compounds according to one of the above formulas wherein $R^4$ represents an alkyl containing 3 to 16 C-atoms. Said (a) hydrophobizing agent(s) is(are) comprised in the finisher preferably in a total concentration between 0.1 g/l and 10 g/l, more preferably in a total concentration between 0.3 g/l and 3 g/l.

Additives improving the oleophilic ink-repellency of the hydrophilic surface areas are e.g. carbohydrates such as acidic polysaccharides like gum arabic, carboxymethylcellulose, sodium alginate, propylene glycol ester of alginic acid, hydroxyethyl starch, dextrin, hydroxyethylcellulose, polyvinyl pyrrolidone, polystyrene sulphonic acid, polyglycols being the reaction products of ethyleneoxide and/or propyleneoxide with water or an alcohol and polyvinyl alcohol. Optionally, hygroscopic substances e.g. sorbitol, glycerol, tri(hydroxyethyl)ester of glycerol, and turkish red oil may be added.

Furthermore (a) surface-active compound(s) is preferably also added to the finisher. The concentration thereof may vary within broad ranges provided the finisher shows no excessive degree of foaming when plates are finished. Preferred surface-active compound are anionic or non-ionic surface-active compound.

A suitable finisher as disclosed in US-A-4.563.410 is a composition comprising a solution of a mercaptotriazole in a solution of polyethylene oxide with a molecular weight of 4,000. Further suitable finishers have been described in i.a. US-A 4.062.682.

At the moment the treatment with the finisher is started the surface carrying the silver pattern may be in dry or wet state. In general, the treatment with the finisher does not take long, usually not longer than about 30 seconds and it may be carried out immediately after the processing and uncovering steps, preferably at a temperature of the finisher in the range from 30°C to 60°C.

The finisher can be applied in different ways such as by rubbing with a roller, by wiping with an absorbent means e.g. with a plug of cotton or sponge, or by dipping the material to be treated in the finisher. The image-hydrophobizing step of the printing plate may also proceed automatically by conducting the printing plate through a device having a narrow channel filled with the finisher and conveying the printing plate at the end of the channel between two squeezing rollers removing the excess of liquid.

As soon as the hydrophilic surface of a support carrying the silver image has been treated with the finisher, it is ready to be used as a printing plate.

The following examples illustrates the present invention without however, limiting it thereto. All parts, percentages and ratios are by weight unless otherwise indicated.

EXAMPLE 1

A 0,30 mm thick aluminium foil (AA 1050) was degreased by immersing the foil in an aqueous solution containing 10 % phosphoric acid and subsequently etched in an aqueous solution containing 2 g/l of sodium hydroxide. The foil was then electrochemically grained using an alternating current in an aqueous solution containing 4 g/l of hydrochloric acid and 4 g/l of hydroboric acid at a temperature of 35°C to form a surface topography with an average center-line roughness Ra of 0,6 µm. The aluminium plate was then desmutted with an aqueous solution containing 30 % of sulfuric acid at 60°C for 120 seconds. The foil was subsequently subjected to anodic oxidation in an aqueous solution containing 200 g/l of sulfuric acid at a temperature of 45°C, a voltage of about 10 V and a current density of 150 A/$m^2$ for about 300 s to form an anodic oxidation film of 3.00 g/$m^2$ of $Al_2O_3$, then washed with demineralised water, posttreated with a solution containing 20 g/l of sodium bicarbonate at 40 °C for 30 s, subsequently rinsed with demineralized water of 20°C during 120 s and finally dried.

The imaging element I was obtained by coating the grained, anodized and posttreated aluminum support with a silver-receptive stratum containing 1.1 mg/$m^2$ PdS as physical development nuclei.

An intermediate layer was then provided on the dry silver-receptive stratum from an aqueous composition in such a way that the resulting dried layer had a weight of 0.5 g of polymethyl methacrylate beads per $m^2$, said composition comprising:

| | |
|---|---|
| a 20 % dispersion of polymethyl methacrylate beads in a mixture of equal volumes of water and ethanol having an average diameter of 1.0 µm | 50 ml |
| Helioechtpapierrot BL (trade mark for a dye sold by BAYER AG, D-5090 Leverkusen, West-Germany) | 2.5 g |
| saponine | 2.5 g |
| sodium oleylmethyltauride | 1.25 g |
| demineralized water | 300 ml |
| (pH-value : 5.6) | |

Finally a substantially unhardened photosensitive negative-working cadmium-free gelatin silver chlorobromoiodide emulsion layer (97.98 / 2 / 0.02 mol%) containing 2.2 mmole/mole AgX of 1-(3-(2-sulphobenzamido)) phenyl-5-mercapto-tetrazole was coated on the intermediate layer, the silver halide being provided in an amount corresponding to 2.40 g of silver nitrate per $m^2$ and the gelatin content of the emulsion layer being 1.58 g/$m^2$, consisting of 0.7 g/$m^2$ of a gelatin with a viscosity of 21 mPa.s and the remainder of a gelatin with a viscosity of 14 mPa.s

Imaging elements II to VII were obtained in an identical way as imaging element I with the exception that to the photosensitive emulsion layer was added 1-phenyl-4-methyl-3-pyrazolidone in an amount as indicated in table 1.

The imaging elements were placed in contact with a test target and exposed therethrough in a process-camera. In the next step each imaging element was immersed for 10 s at 24°C in a freshly made developing solution having the following composition:

| | |
|---|---|
| carboxymethylcellulose | 4 g |
| sodium hydroxide | 22.5 g |
| anhydrous sodium sulphite | 120 g |
| hydroquinone | 20 g |
| 1-phenyl-4-methyl-3-pyrazolidinone | 6 g |
| potassium bromide | 0.75 g |
| anhydrous sodium thiosulphate | 8 g |
| ethylene diamine tetraacetic acid tetrasodium salt | 2 g |
| demineralized water to make | 1000 ml |
| pH (24°C) = 13 | |

The initiated diffusion transfer was allowed to continue for 20 s to form a silver image in the image receiving layers.

To remove the developed silver halide emulsion layer and the intermediate layer from the aluminium foil the developed monosheet DTR materials were rinsed for 5 s with a water jet at 40°C in a LP 82 (tradename of a processor marketed by Agfa-Gevaert, Belgium).

The sensitometric results are given in table 1.

Table 1

| No. | Conc. a) | Sens. b) | Sens.Stor. c) | Δ Sens. |
|---|---|---|---|---|
| 1 | 0 | 56 | 73 | 17 |
| 2 | 0.5 | 53 | 61 | 8 |
| 3 | 1 | 52 | 57 | 5 |
| 4 | 2 | 50 | 55 | 5 |
| 5 | 4 | 50 | 53 | 3 |
| 6 | 10 | 50 | 53 | 3 |
| 7 d) | 20 | - | - | - |

a) Concentration on 1-phenyl-4-methyl-3-pyrazolidone in mg/g-silver halide expressed as an equivalent amount of silver nitrate

b) Sens : sensitivity measured at the point $\frac{Dmax+Dmin}{2}$ A higher number means a higher sensitivity.

c) Sens.Stor. : sensitivity after storage for 5 days at 57°C and 34% relative humidity

d) The coating layer could not be coated anymore due to coagulation of the emulsion

It is clear that the fresh imaging materials II to VI containing 1-phenyl-4-methyl-3-pyrazolidone (imaging elements according to the invention) have indeed a slightly lower sensitivity than the imaging element I containing no

1-phenyl-4-methyl-3-pyrazolidone (comparison element) but that these imaging elements show only a moderate to a very slight loss in sensitivity upon storage while the imaging element I shows an appreciable loss in sensitivity upon storage.

EXAMPLE II

Imaging elements VIII to XII were prepared, exposed and processed in an identical way as imaging element I with the exception that to the photosensitive emulsion layer was added 1-phenyl-4-hydroxymethyl-4-methyl-3-pyrazolidone in an amount as indicated in table 2.

The sensitometric results are given in table 2.

Table 2

| No. | Conc. a) | Sens. b) | Sens.Stor.c) | Δ Sens. |
|---|---|---|---|---|
| 1 | 0 | 61 | 81 | 20 |
| 8d) | 2 | 58 | 60 | 2 |
| 9 d) | 4 | 56 | 57 | 1 |
| 10d) | 6 | 55 | 55 | 0 |
| 11d) | 8 | 51 | 51 | 0 |
| 12e) | 20 | - | - | - |

a) Concentration on 1-phenyl-4-hydroxymethyl-4-methyl-3-pyrazolidone in mg/g-silver halide expressed as an equivalent amount of silver nitrate

b) Sens : sensitivity measured at the point $\frac{Dmax+Dmin}{2}$ A higher number means a higher sensitivity.

c) Sens.Stor. : sensitivity after storage for 5 days at 57°C and 34% relative humidity

d) The removal of the developed silver halide emulsion layer and the intermediate layer becomes (very) difficult

e) The removal of the developed silver halide emulsion layer and the intermediate layer is not longer possible

It is clear that the fresh imaging materials VIII to XI containing 1-phenyl-4-hydroxymethyl-4-methyl-3-pyrazolidone (imaging elements according to the invention) have indeed a slightly to a moderately lower sensitivity than the imaging element I containing no 1-phenyl-4-hydroxymethyl-4-methyl-3-pyrazolidone (comparison element) but that these imaging elements show only a very slight to no loss in sensitivity upon storage while the imaging element I shows an appreciable loss in sensitivity upon storage.

However, the removal of the developed silver halide emulsion layer and the intermediate layer becomes (very) difficult and finally impossible when the concentration on 1-phenyl-4-hydroxymethyl-4-methyl-3-pyrazolidone increases.

## Claims

1. An imaging element comprising in the order given on a hydrophilic surface of a support (i) an image receiving layer containing physical development nuclei and (ii) a photosensitive layer containing a silver halide emulsion being in water permeable relationship with said image receiving layer, characterized in that said photosensitive layer comprises a substituted or unsubstituted 1-phenyl-3-pyrazolidone in an amount between 0.2 mg/g and 15 mg/g of silver halide expressed as an equivalent amount of silver nitrate.

2. An imaging element according to claim 1 wherein said 1-phenyl-3-pyrazolidone is a 1-phenyl-3-pyrazolidone substituted in the 4 position.

3. An imaging element according to claim 1 wherein said 1-phenyl-3-pyrazolidone is 1-phenyl-4-methyl-3-pyrazolidone.

4. An imaging element according to any of claims 1 to 3 wherein said substituted or unsubstituted 1-phenyl-3-pyrazolidone is used in an amount between 0.4 mg/g and 12 mg/g of silver halide expressed as an equivalent amount of silver nitrate.

5. An imaging element according to claim 4 wherein said substituted or unsubstituted 1-phenyl-3-pyrazolidone is used in an amount between 1 mg/g and 12 mg/g of silver halide expressed as an equivalent amount of silver nitrate.

6. An imaging element according to any of claims 1 to 5 wherein said photosensitive layer contains 1-phenyl-5-mercapto-tetrazoles substituted by the amido goup $-NR_1-CO-R_2$ or $-NR_1-SO_2-R_2$ wherein $R_1$ represents hydrogen or $C_1-C_4$ alkyl and $R_2$ represents a hydrocarbon group selected from the group consisting of $C_1-C_8$ alkyl, aryl, and alkenyl wherein said hydrocarbon group is substituted by a -COOM group or a $-SO_3M$ group with M representing hydrogen,a metal cation or an ammonium group.

**7.** A method for making an offset printing plate according to the silver salt diffusion transfer process comprising the steps of:

(a) image-wise exposing an imaging element according to any of the claims 1 to 6,
(b) applying an aqueous alkaline solution to the imaging element in the presence of (a) developing agent(s) and (a) silver halide solvent(s) ,
(c) treating the imaging element to remove the layer(s) on top of said image receiving layer, thereby uncovering said silver image formed in said image receiving layer.

## Patentansprüche

**1.** Ein bilderzeugendes Element, das der angegebenen Reihe nach auf einer hydrophilen Oberfläche eines Trägers (i) eine physikalische Entwicklungskeime enthaltende Bildempfangsschicht und (ii) eine lichtempfindliche Silberhalogenid-Emulsionsschicht in wasserdurchlässiger Beziehung zur Bildempfangsschicht enthält, dadurch gekennzeichnet, daß die lichtempfindliche Schicht ein substituiertes oder nicht-substituiertes 1-Phenyl-3-pyrazolidon in einer Menge zwischen 0,2 mg und 15 mg pro Gramm als eine äquivalente Menge Silbernitrat ausgedrucktes Silberhalogenid enthält.

**2.** Bilderzeugendes Element nach Anspruch 1, dadurch gekennzeichnet, daß das 1-Phenyl-3-pyrazolidon ein in der 4-Stellung substituiertes 1-Phenyl-3-pyrazolidon ist.

**3.** Bilderzeugendes Element nach Anspruch 1, dadurch gekennzeichnet, daß das 1-Phenyl-3-pyrazolidon 1-Phenyl-4-methyl-3-pyrazolidon ist.

**4.** Bilderzeugendes Element nach irgendeinem der Ansprüche 1 bis 3, dadurch gekennzeichnet, daß das substituierte oder nicht-substituierte 1-Phenyl-3-pyrazolidon in einer Menge zwischen 0,4 mg und 12 mg pro Gramm als eine äquivalente Menge Silbernitrat ausgedrucktes Silberhalogenid benutzt wird.

**5.** Bilderzeugendes Element nach Anspruch 4, dadurch gekennzeichnet, daß das substituierte oder nicht-substituierte 1-Phenyl-3-pyrazolidon in einer Menge zwischen 1 mg und 12 mg pro Gramm als eine äquivalente Menge Silbernitrat ausgedrucktes Silberhalogenid benutzt wird.

**6.** Bilderzeugendes Element nach irgendeinem der Ansprüche 1 bis 5, dadurch gekennzeichnet, daß die lichtempfindliche Schicht durch die Amidgruppe $-NR_1-CO-R_2$ oder $-NR_1-SO_2-R_2$ substituierte 1-Phenyl-5-mercaptotetrazole enthält, bei denen $R_1$ ein Wasserstoffatom oder eine $C_1-C_4$-Alkylgruppe und $R_2$ eine Kohlenwasserstoffgruppe aus der Gruppe bestehend aus einer $C_1-C_8$-Alkylgruppe, einer Arylgruppe und einer Alkenylgruppe bedeutet, wobei die Kohlenwasserstoffgruppe durch eine -COOM-Gruppe oder eine $-SO_3M$-Gruppe substituiert ist, wobei M ein Wasserstoffatom, ein Metallkation oder eine Ammoniumgruppe bedeutet.

**7.** Ein Verfahren zur Herstellung einer Offsetdruckplatte nach dem Silbersalz-Diffusionsübertragungsverfahren, das folgende Stufen umfaßt :

- die bildmäßige Belichtung eines bilderzeugenden Elements nach irgendeinem der Ansprüche 1 bis 6,
- den Auftrag einer wäßrigen alkalischen Lösung auf das bilderzeugende Element in Gegenwart einer oder mehrerer Entwicklersubstanzen und eines oder mehrerer Silberhalogenid-Lösungsmittel,
- die Verarbeitung des bilderzeugenden Elements zur Entfernung der auf der Bildempfangsschicht befindlichen Schicht(en), wodurch das in der Bildempfangsschicht erzeugte Silberbild aufgedeckt wird.

## Revendications

**1.** Un élément formateur d'image comprenant dans l'ordre indiqué sur une surface hydrophile d'un support (i) une

couche réceptrice d'image contenant des germes de développement physique et (ii) une couche d'émulsion à l'halogénure d'argent photosensible étant en relation de perméabilité à l'eau avec la couche réceptrice d'image, caractérisé en ce que la couche photosensible comprend une 1-phényl-3-pyrazolidone substituée ou non substituée dans une quantité comprise entre 0,2 mg et 15 mg par gramme d'halogénure d'argent exprimé comme une quantité équivalente de nitrate d'argent.

**2.** Elément formateur d'image selon la revendication 1, caractérisé en ce que la 1-phényl-3-pyrazolidone est une 1-phényl-3-pyrazolidone substituée sur la position 4.

**3.** Elément formateur d'image selon la revendication 1, caractérisé en ce que la 1-phényl-3-pyrazolidone est de la 1-phényl-4-méthyl-3-pyrazolidone.

**4.** Elément formateur d'image selon l'une quelconque des revendications 1 à 3, caractérisé en ce que la 1-phényl-3-pyrazolidone substituée ou non substituée est utilisée dans une quantité comprise entre 0,4 mg et 12 mg par gramme d'halogénure d'argent exprimé comme une quantité équivalente de nitrate d'argent.

**5.** Elément formateur d'image selon la revendication 4, caractérisé en ce que la 1-phényl-3-pyrazolidone substituée ou non substituée est utilisée dans une quantité comprise entre 1 mg et 12 mg par gramme d'halogénure d'argent exprimé comme une quantité équivalente de nitrate d'argent.

**6.** Elément formateur d'image selon l'une quelconque des revendications 1 à 5, caractérisé en ce que la couche photosensible contient des 1-phényl-5-mercaptotétrazoles substitués par le groupe amide $-NR_1-CO-R_2$ ou $-NR_1-SO_2-R_2$, dans lesquels $R_1$ représente un atome d'hydrogène ou un groupe alkyle en $C_1$-$C_4$ et $R_2$ représente un groupe hydrocarbure choisi du groupe composé d'un groupe alkyle en $C_1$-$C_8$, d'un groupe aryle et d'un groupe alkényle, le groupe hydrocarbure étant substitué par un groupe -COOM ou un groupe $-SO_3M$, dans lesquels M représente un atome d'hydrogène, un cation métallique ou un groupe ammonium.

**7.** Un procédé pour la confection d'une plaque d'impression offset selon le procédé de transfert de sels d'argent par diffusion, comprenant les phases ci-après :

- l'exposition sous forme d'image d'un élément formateur d'image selon l'une quelconque des revendications 1 à 6,
- l'application d'une solution alcaline aqueuse sur l'élément formateur d'image en présence d'un ou plusieurs révélateurs et d'un ou plusieurs solvants des halogénures d'argent,
- le traitement de l'élément formateur d'image afin de séparer la (les) couche(s) située(s) sur la couche réceptrice d'image et de découvrir ainsi l'image argentique formée dans la couche réceptrice d'image.